Europäisches Patentamt

European Patent Office

Office européen des brevets

(19)

(11) Veröffentlichungsnummer: **0 048 858**
**B1**

# (12) EUROPÄISCHE PATENTSCHRIFT

(45) Veröffentlichungstag der Patentschrift:
08.01.86

(51) Int. Cl.⁴: **H 01 J 37/28, G 06 G 7/18**

(21) Anmeldenummer: **81107147.1**

(22) Anmeldetag: **10.09.81**

(54) **Vorrichtung zur Signalverarbeitung für ein Elektronenstrahl-Messgerät.**

(30) Priorität: **29.09.80 DE 3036708**

(43) Veröffentlichungstag der Anmeldung:
**07.04.82 Patentblatt 82/14**

(45) Bekanntmachung des Hinweises auf die Patenterteilung:
**08.01.86 Patentblatt 86/2**

(84) Benannte Vertragsstaaten:
**DE FR GB NL**

(56) Entgegenhaltungen:
**US - A - 3 535 516**

**IEEE JOURNAL OF SOLID-STATE CIRCUITS, Band SC-13, Nr. 3, 1978 New York H.P. FEUERBAUM et al. "Quantitative Measurement with High Time Resolution on Internal Waveforms on MOS RAM's Using a Modified Scanning Electron Microscope" Seiten 319 bis 325**
**JOURNAL OF PHYSICS E. SCIENTIFIC INSTRUMENTS, Band 5, 1972, London L. NIEMELA "A Boxcar Integrator for Pulsed NMR Relaxation Time Measurements" Seiten 526 bis 528**
**REVIEW OF SCIENTIFIC INSTRUMENTS, Band 51, Nr. 9, September 1980 New York R.P. ATANASOV "A Deep Level Transient Spectroscopy System Using Single-Gated Signal Averager" Seiten 1277 bis 1279**
**IEEE JOURNAL OF SOLID-STATE-CIRCUITS, Band**

(73) Patentinhaber: **Siemens Aktiengesellschaft, Berlin und München Wittelsbacherplatz 2, D-8000 München 2 (DE)**

(72) Erfinder: **Feuerbaum, Hans-Peter, Dipl.-Phys., Tucholskystrasse 22, D-8000 München 83 (DE)**

(56) Entgegenhaltungen: (Fortsetzung)
**SC-14, nr. 2, April 1979 New York E. WOLFGANG et al. "Electron-Beam Testing of VLSI Circuits" Seiten 471 bis 481**

## Beschreibung

Die Erfindung betrifft eine Vorrichtung zur Signalverarbeitung für ein Elektronenstrahl-Messgerät nach dem Oberbegriff des Anspruchs 1.

Hochfrequente periodische Vorgänge in integrierten Schaltungen können mit einer Elektronensonde stroboskopisch gemessen werden. Als Prüfsonde dient dabei ein fein fokussierter Elektronenstrahl, der auf das Messobjekt gerichtet wird. Durch die Wechselwirkung zwischen Elektronen und Festkörper werden u.a. Sekundärelektronen ausgelöst, die zur Abbildung eines Objekts herangezogen werden können. Diese Sekundärelektronen tragen auch Informationen über das elektrische Potential am Auftreffort. Unter Ausnutzung des Stroboskopie-Effektes können auch mit hoher Nenn-Frequenz arbeitende Messobjekte quasistatisch im Potentialkontrast abgebildet werden. Zu diesem Zweck wird das zu untersuchende Messobjekt mit sich zyklisch wiederholenden Signalen angesteuert und in einem Raster-Elektronenmikroskop abgebildet. Der Elektronenstrahl wird in jedem Zyklus nur einmal für kurze Zeit eingeschaltet, d.h. das Messobjekt wird nur während einer bestimmten Phase betrachtet. Die Abbildung ist somit eine Momentaufnahme der schnell arbeitenden Probe. Der Einschaltzeitpunkt des Elektronenstrahles kann innerhalb des Zyklus beliebig gewählt werden. Durch langsames Verschieben der Phase ist eine Zeitlupendarstellung der Schaltvorgänge möglich. Die Einschaltdauer des Elektronenstrahles kann bis zum ps-Bereich reduziert werden, das heisst, die Zeitauflösung dieses Abbildungsverfahrens liegt im ps-Bereich. Die Elektronenpulse werden mit Hilfe eines Strahlaustastsystems erzeugt.

Das Potential am Auftreffort der Primärelektronen wird mit Hilfe eines Spektrometers aus der Energie der pulsförmig ausgelösten Sekundärelektronen bestimmt. Dazu wird das Signal der Sekundärelektronen, die das Spektrometer durchlaufen haben, in einer Szintillator-Fotomultiplierkombination verstärkt und nach einer Integration in einem Vorverstärker weiterverarbeitet. Die Anordnung erfordert

1) eine Phasensteuerung, mit der die Phase der Elektronenpulse eingestellt wird, und
2) einen Vorverstärker, der pulsförmige Signale ohne Übersteuerung verarbeiten kann.

Da kommerzielle Geräte mit der geforderten Leistungsfähigkeit nicht erhältlich sind, mussten bei den bisher bekannten Elektronenstrahl-Messgeräten zur stroboskopischen Messung hochfrequenter periodischer Vorgänge die verschiedenen Komponenten entwickelt werden. (E. Wolfgang et al, «Electron-beam testing of VLSI Circuits», IEEE J. of Solid-State Circuits, Vol.SC-14, No. 2 Apr. 1979, 471–481). Im einzelnen wurden dabei die folgenden Komponenten aufgebaut:
a) Zur Phasensteuerung wurde ein Verzögerungsgenerator (Hewlett-Packard) modifiziert.
b) Zur Ansteuerung des Verzögerungsgenerators wurde eine spezielle Elektronik entwickelt.
c) Zur Signalverarbeitung wurde ein Vorverstärker aufgebaut, der zusammen mit einem Regelverstärker eine Potentialmessung ermöglicht.

Trotz grösserer Anstrengungen genügt das Gerät aber nicht den neueren Anforderungen bezüglich Leistungsfähigkeit, Zuverlässigkeit und Handhabung.

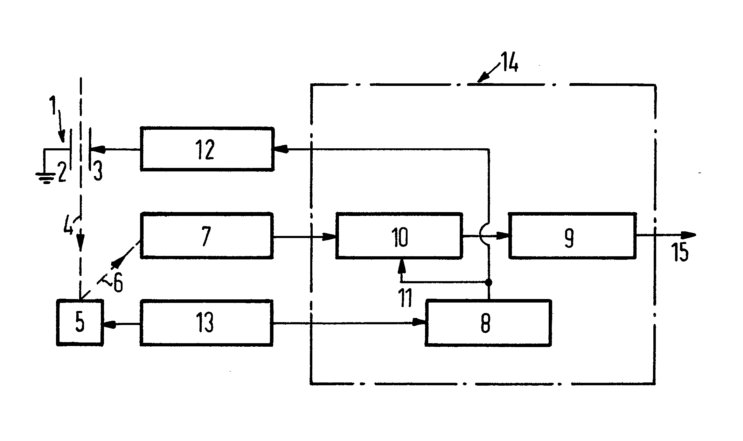

Aus «Journal of Physics E: Scientific Instruments», Bd. 5, 1972, London, Seiten 526–528, ist ein Boxcar-Integrator mit einer Einrichtung zur Phasensteuerung und mit einer Einrichtung zur Signalverarbeitung in Verbindung mit NMR-Relaxationszeitmessungen beschrieben. Dabei wird zum definierten Vergleich von Signalen zweier Signalkanäle jeweils nach Anregung eines Vorganges in einem Messobjekt nach einer definierten Zeitverzögerung ein definiertes Zeitfenster gesetzt. Der Boxcar-Integrator dient dabei nur dazu, die Erregung eines Vorganges und damit den Vorgang selbst mit der Signalverarbeitung in definierter Weise zu synchronisieren. Eine definierte Signalverarbeitung lediglich synchron mit einem Vorgang in einem Messobjekt genügt jedoch ebenfalls noch nicht den neueren Anforderungen bezüglich Leistungsfähigkeit, Zuverlässigkeit und Handhabung. Aus der Veröffentlichung «Review of Scientific Instruments», Vol. 49, No. 9, Sept. 1978, 1293–1299, insbesondere Fig. 9, ist eine Verwendung eines Boxcar-Integrators bei der Signalverarbeitung in der Elektronenstrahl-Messtechnik bekannt. Eine Messanordnung nach dieser Veröffentlichung ist genauso empfindlich gegen Störungen des Strahlaustastsystems und abhängig von der Abtastfrequenz und genauso schwierig zu handhaben, wie dies weiter oben zum Stand der Technik angegeben worden ist.

Der Erfindung liegt die Aufgabe zugrunde, eine Vorrichtung der eingangs genannten Art anzugeben, die ein leistungsfähiges und zuverlässiges Elektronenstrahl-Messgerät zur stroboskopischen Messung hochfrequenter periodischer Vorgänge ermöglicht, welches zusätzlich auch noch einfach handzuhaben ist.

Diese Aufgabe wird erfindungsgemäss durch eine Vorrichtung nach dem Anspruch 1 gelöst.

Gegenüber der bekannten Anordnung bietet eine erfindungsgemässe Ausführungsform folgende Vorteile:
a) Die Signalverarbeitung ist unempfindlich gegen Störungen des Strahlaustastsystems und unabhängig von der Abtastfrequenz.
b) Die Synchronisation erfolgt automatisch.
c) Das Signalrauschverhältnis wird verbessert.
d) Ansteuerung der erfindungsgemässen Anordnung über einen Rechner sollte einfach sein.
e) Die Kostenersparnis beträgt 50%.

Ein Ausführungsbeispiel der Erfindung ist in der Zeichnung dargestellt und wird im folgenden näher beschrieben.

Die Figur zeigt eine erfindungsgemässe Anordnung für stroboskopische Potentialmessungen mit einem Elektronenstrahl-Messgerät.

In der Figur ist eine erfindungsgemässe Anordnung für stroboskopische Potentialmessungen mit einem Elektronenstrahl-Messgerät dargestellt. Als Grundlage für eine erfindungsgemässe Anordnung kann ein Elektronenstrahl-Messgerät nach dem angegebenen Stand der Technik verwendet werden, welches dann erfindungsgemäss zu modifizieren ist. Die Grundeinheit bildet ein modifiziertes Rasterelektronenmikroskop mit einem schnellen Strahlaustastsystem 1. Dieses Strahlaustastsystem 1 besitzt die beiden Ablenkstrukturen 2, 3. Um hochfrequente periodische Vorgänge im Messobjekt 5 stroboskopisch zu messen, wird ein Elektronenstrahl 4 von Primärelektronen synchron mit dem Vorgang gepulst, so dass er das Messobjekt 5 nur in einer bestimmten Phase des hochfrequenten periodischen Vorgangs trifft. Das Potential in dieser Phase des hochfrequenten periodischen Vorgangs wird mit Hilfe eines Spektrometers aus der Energie der pulsförmig ausgelösten Sekundärelektronen 6 bestimmt. Dazu wird das Signal der Sekundärelektronen 6, die das Spektrometer durchlaufen haben, in einer Szintillator-Fotomultiplierkombination 7 verstärkt und in einem modifizierten Boxcar-Integrator 14 weiterverarbeitet. Er übernimmt dabei die Steuerung der Phase und die Signalverarbeitung. Ein Boxcar-Integrator ist ein Verstärker, der hochfrequente Signale mit einem Zeitfenster (gate) nach dem sampling-Prinzip abtastet. Bei Verwendung eines Boxcar-Integrators wird das Potential in einer Phase wiederholt gemessen und integriert. Infolge der Integration liefert die Verwendung eines Boxcar-Integrators ein verbessertes Signal-Rausch-Verhältnis. Nach erfolgter Integration wird die Phase verschoben. Auf diese Weise kann ein periodischer Signalverlauf abgetastet werden. Der Boxcar-Integrator 14 weist eine Phasensteuerungseinheit 8, eine Signalverarbeitungseinheit 9 und eine Torschaltung 10 auf. Das Signal der Sekundärelektronen 6 gelangt nach der Verstärkung in der Szintillator-Fotomultiplierkombination 7 an den Eingang der Torschaltung 10. Die bei einer bestimmten Phase des hochfrequenten periodischen Vorgangs im Messobjekt 5 gemessenen Werte werden in der Signalverarbeitungseinheit 9 integriert und anschliessend verstärkt. Zur Anwendung in der Elektronenstrahl-Messtechnik muss am Boxcar-Integrator 14 folgende Änderung durchgeführt werden: Zwischen der Phasensteuerungseinheit 8 und der Torschaltung 10 wird eine Verzögerungsschaltung 11 (ca. 150 ns) eingebaut. Ohne Verzögerung steuert die Phasensteuerungseinheit 8 den Pulsgenerator 12 des Strahlaustastsystems 1. Das Signal der ausgelösten Sekundärelektronen 6 erscheint infolge Laufzeit der Primärelektronen 4 mit einer Verzögerung am Eingang der Torschaltung 10. Zur gleichen Zeit, wenn das Signal der ausgelösten Sekundärelektronen 6 am Eingang der Torschaltung erscheint, wird die Torschaltung über die eingebaute Verzögerungsschaltung 11 so angesteuert, dass das Signal der Sekundärelektronen 6 verstärkt wird. Der Boxcar-Integrator 14 liefert ein Signal 15, das der Höhe des Signals der ausgelösten Sekundärelektronen 6 proportional ist. Die gesamte Anordnung weist noch ein elektronisches Zusatzgerät 13 zur Ansteuerung des Messobjekts 5 und zur Ansteuerung der Phasensteuerungseinheit 8 auf. Als Boxcar-Integrator 14 wurde das Gerät Model 162 der Fa. PAR verwendet.

**Patentanspruch**

Vorrichtung zur Signalverarbeitung für ein Elektronenstrahl-Messgerät, mit dem ein hochfrequenter Vorgang, der in einem Messobjekt (5) von Mitteln (13) zur Erzeugung des hochfrequenten Vorganges hervorgerufen wird, stroboskopisch gemessen werden kann, welches Elektronenstrahl-Messgerät ein Strahlaustastsystem (1) zur Erzeugung hochfrequenter Primärelektronenpulse (4), einen Detektor (7) zum Nachweis von Sekundärelektronen (6), die von den Primärelektronen (4) an einem Messpunkt ausgelöst werden, und Mittel (12) zur Ansteuerung des Strahlaustastsystems (1) aufweist, gekennzeichnet durch einen Boxcar-Integrator (14), der eine Torschaltung (10), Mittel (9) zur Signalverarbeitung, Mittel (8) zur Phasensteuerung und Mittel (11) zur Verzögerung eines Signals zwischen den Mitteln (8) zur Phasensteuerung und der Torschaltung (10) aufweist, wobei die Mittel (8) zur Phasensteuerung mit den Mitteln (13) zur Erzeugung eines hochfrequenten Vorganges synchronisiert sind, wobei die Torschaltung (10) für jedes Sekundärelektronensignal ein Zeitfenster setzt, wobei die so behandelten Sekundärelektronensignale nach der Torschaltung (10) zu den Mitteln (9) zur Signalverarbeitung gelangen, und wobei die Mittel (8) zur Phasensteuerung den Betrieb der Mittel (12) zur Ansteuerung des Strahlaustastsystems (1) und den Betrieb der Torschaltung (10) simultan mit einer jeweils bestimmten Phase des hochfrequenten Vorganges am Messpunkt synchronisieren.

**Claim**

A signal processing for an electron beam measuring apparatus, by which a high-frequency process caused in an object to be measured (5) by means (13) for producing the high-frequency process can be stroboscopically measured, which electron beam measuring apparatus possesses a beam blanking system (1) for generating high-frequency primary electron pulses (4), a detector (7) for detecting secondary electrons (6) triggered by the primary electrons (4) at the measuring point, and means (12) fo controlling the beam blanking system (1), characterised by a boxcar integrator (14) which has a gate circuit (10), means (9) for the signal processing, means (8) for the phase control and means (11) for delaying a signal between the means (8) for the phase control and the gate circuit (10), where the means (8) for the phase control are synchronised with the means (13) for producing a high-frequency process, where the gate circuit (10) sets a time window for each secondary electron signal, where the secondary electron signals treated in this manner are fed to the means (9) for the signal processing after the gate circuit (10), and where the means (8) for the phase control simultaneously synchronise the operation of the means (12) for controlling the beam blanking system (1) and the operation of the gate circuit (10) with a respectively determined phase of the high-frequency process at the measuring point.

**Revendication**

Dispositif de traitement de signaux pour un appareil de mesure à faisceau d'électrons, à l'aide duquel un processus à haute fréquence, qui est provoqué dans un objet de mesure (5) par des moyens (13) servant à produire le processus à haute fréquence, peut être mesuré par voie stroboscopique, lequel appareil de mesure à faisceau d'électrons comporte un système(1) de suppression du faisceau, servant à produire des impulsions (4) d'électrons primaires à haute fréquence un détecteur (7) servant à détecter des secondaires (6), qui sont déclenchés par les électrons primaires (4) en un point de mesure, et des moyens (12) servant à commander le système (1) de suppression du faisceau, caractérisé par un intégrateur Boxcar (14), qui comprend un circuit de porte (10), des moyens (9) prévus pour traiter les signaux, des moyens (8) prévus pour réaliser la commande de phase et des moyens (11) prévus pour retarder un signal et situés entre les moyens (8) prévus pour la commmande de phase et le circuit de porte (10), les moyens (8) prévus pour réaliser la commande de phase étant synchronisés avec les moyens (13) servant à produire un processus à haute fréquence, le circuit de porte (10) positionnant une fenêtre temporelle pour chaque signal d'électrons secondaires, les signaux ainsi traités des électrons secondaires parvenant, en aval du circuit de porte (10), aux moyens (9) prévus pour le traitement des signaux, et les moyens (8) prévus pour réaliser la commande de phase synchronisant simultanément le fonctionnement des moyens (12) prévus pour réaliser la commande du système (1) de suppression du faisceau et le fonctionnement du circuit de porte (10), sur une phase respective déterminée du processus à haute fréquence au niveau du point de mesure.